# EUROPEAN PATENT APPLICATION

(11) **EP 4 482 270 A1**
(43) Date of publication of application: **25.12.2024**
(21) Application number: 24183380.5
(22) Date of filing: 20.06.2024
(51) Int. Cl.: H05K 7/20

(54) **SERVER COOLING WITH IMMERSED HEAT SINK**

(30) Priority: 20.06.2023 US 202363509104 P
(71) Applicant: Carrier Corporation, Palm Beach Gardens, FL 33418 (US)
(72) Inventor: TRUONG, My, Pacifica, CA 94044 (US); PICHAI, Tikhon Suresh, Simpsonville, SC 29681 (US); JOARDAR, Arindom, Syracuse, NY 13221 (US)
(74) Representative: Dehns

(57) **Abstract**

A method of cooling an assembly (100) including at least one heat-generating electronic device (50) and at least one peripheral heat-generating device (50) encapsulated within a container (102) includes cooling the at least one peripheral heat-generating device (50) with a first cooling medium (C1), cooling the at least one heat-generating electronic device (50) with a heat sink (110) having an internal fluid circuit configured to receive a second cooling medium, and cooling the first cooling medium (C1) via the heat sink (110).

## Description

### BACKGROUND

Exemplary embodiments pertain to the art of thermal management, and more particularly, relate to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating devices mounted thereto. The printed circuit boards are commonly housed in an enclosure having vents configured to direct external air from the data center into, through and out of the enclosure. The air absorbs heat dissipated by the components and after being exhausting from the enclosure, mixes with the ambient air. An air conditioner is then used to cool the heated air of the data center and to recirculate it, repeating the cooling process.

Higher performance server components typically dissipate more power. However, the amount of heat that conventional cooling system can remove from a server is in part limited by the extent of the air conditioning available from the data center. There is therefore a need to more effectively cool high performance server components.

### BRIEF DESCRIPTION

According to a first aspect there is provided a method of cooling an assembly including at least one heat-generating electronic device and at least one peripheral heat-generating device encapsulated within a container includes cooling the at least one peripheral heat-generating device with a first cooling medium, cooling the at least one heat-generating electronic device with a heat sink having an internal fluid circuit configured to receive a second cooling medium, and cooling the first cooling medium via the heat sink. The heat sink may be, or comprise, a cold plate.

The method may comprise circulating the first cooling medium within the container.

The first cooling medium may be cooled via the heat sink at a location upstream from the at least one peripheral heat-generating device relative to a direction of flow of the first cooling medium.

The method may comprise cooling the at least one heat-generating electronic device with the first medium.

Cooling the at least one heat-generating electronic device with the cold plate having the internal fluid circuit may comprise transferring heat from the at least one heat-generating electronic device to a body of the cold plate and transferring heat from the body of the cold plate to the second cooling medium within the fluid circuit.

The at least one heat-generating electronic device may be directly mounted to a surface of the cold plate.

The at least one heat-generating electronic device may be directly mounted to a printed circuit board and the cold plate may be thermally coupled to the printed circuit board.

Cooling the at least one heat-generating electronic device with the cold plate having the internal fluid circuit may comprise positioning a portion of the fluid circuit in overlapping arrangement with the at least one heat-generating electronic device.

Cooling the first cooling medium via the heat sink may comprise conducting heat from the first cooling medium to a body of the cold plate and transferring heat from the body of the cold plate to the second cooling medium.

The first cooling medium may be a dielectric fluid.

The second cooling medium may be a refrigerant.

According to a second aspect there is provided an assembly comprising a fluid-tight container, at least one heat-generating electronic device arranged within the container, at least one peripheral heat-generating device arranged within the container, and a first cooling medium arranged within the container, the at least one heat-generating electronic device and the at least one peripheral heat-generating device being encapsulated by the first cooling medium; and a heat sink thermally coupled to the at least one heat-generating electronic device, the heat sink having an internal fluid circuit configured to receive a second cooling medium. The heat sink may be, or comprise, a cold plate.

The at least one heat-generating electronic device may be directly mounted to the cold plate.

The assembly may comprise a printed circuit board, wherein the at least one heat-generating electronic device is directly mounted to the printed circuit board and the cold plate is thermally coupled to the printed circuit board.

The assembly may comprise a movement mechanism for moving the first cooling medium within the container.

At least a portion of the internal fluid circuit may be positioned in overlapping arrangement with the at least one heat-generating electronic device.

The internal fluid circuit of the cold plate may include a single continuous path.

The internal fluid circuit of the cold plate may include a first manifold, a second manifold, and at least one fluid passage connecting the first and second manifolds.

The first cooling medium may be a dielectric fluid.

### BRIEF DESCRIPTION OF THE DRAWINGS

The following descriptions are provided by way of example only and should not be considered limiting in any way. With reference to the accompanying drawings, like elements are numbered alike:
FIG. 1 is a front view of a data center rack having a plurality of servers mounted therein;
FIG. 2A is a perspective view of a server;
FIG. 2B is a cross-sectional side view of a server;
FIG. 3 is a cross-sectional view of an assembly including a server having an integral cooling system;
FIG. 4 is a cross-sectional view of an internal fluid circuit of a heat sink;
FIG. 5 is a cross-sectional view of another internal fluid circuit of a heat sink; and
FIG. 6 is a cross-sectional view of data center including a plurality of assemblies of FIG. 3.

### DETAILED DESCRIPTION

A detailed description of one or more embodiments of the disclosed apparatus and method are presented herein by way of exemplification and not limitation with reference to the Figures.

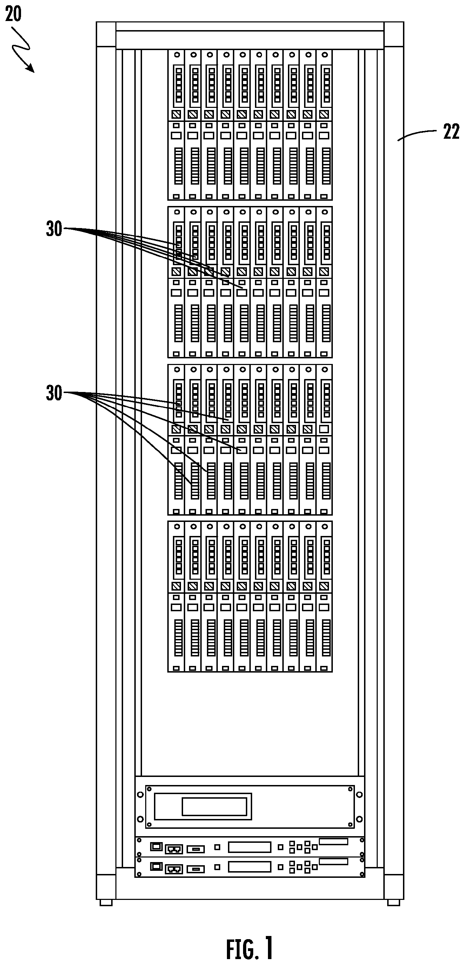

With reference now to FIG. 1, an example of a data center 20 is illustrated. As shown, the data center 20 includes a cabinet 22 having at least one, and in some embodiments, a plurality of slots (not shown) formed therein. One or more server rack sub-assemblies, also referred to herein as servers 30 may be permanently or removably mountable within the cabinet 22, such as within the one or more slots formed therein. The plurality of slots, and therefore the at least one server 30 receivable therein, may have a generally vertical orientation (shown), or alternatively, may have a horizontal orientation. In some embodiments, the data center 20 may include a combination of both horizontally oriented and vertically oriented slots. Further, although only a single cabinet 22 is illustrated in the FIG., it should be appreciated that the data center 20 may includes several cabinets 22. In embodiments including a plurality of cabinets 22, the plurality of cabinets 22 may be arranged at the same location within a building, or alternatively, one or more of the cabinets 22 may be arranged at a different location within a single building or within multiple buildings.

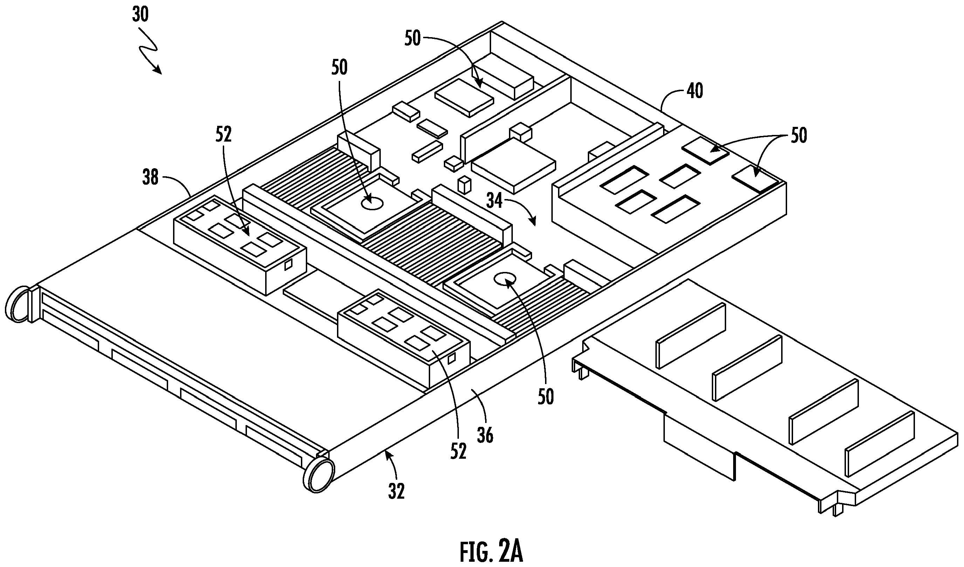

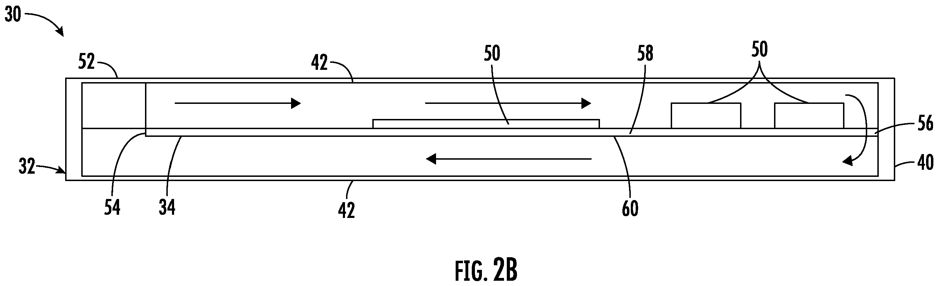

With reference now to FIG. 2, an example of a server 30 receivable within a slot of the cabinet 22 is illustrated. As shown, the server 30 may include a frame or chassis 32 having at least one printed circuit board 34 mounted to the frame. Although only a single printed circuit board 34 is illustrated in the FIG., it should be understood that in some embodiments, a plurality of printed circuit boards may be mounted to the chassis 32. The chassis 32 is designed to be insertable, for example slidably insertable, into a slot of a server rack and allow for connection to power cables, data cables, and/or other connecting cables provided at or by the cabinet 22.

The chassis 32 may include a plurality of walls 36, 38, 40 oriented at an angle to the printed circuit board 34 and that extend about all or at least a portion of a periphery of the printed circuit board 34. In an embodiment, best shown in FIG. 2B, the chassis 32 additionally includes at least one flat, generally planar panel connected to one or more of the peripheral walls 36,38, 40 of the chassis 32. The at least one flat panel 42 may be arranged at either a first side or a second side of the printed circuit board 34. When the server 30 is in a horizontal orientation as shown, such a flat panel 42 may be disposed vertically underneath the printed circuit board 34, vertically above the printed circuit board 34, or in some embodiments, a flat panel 42 may be arranged both above and below the printed circuit board. In an embodiment, the chassis 32 in combination with the flat panels 42 form an air-tight container surrounding the server 30. However, embodiments where a separate jacket or container is positioned about the server 30 to form an air-tight assembly are also contemplated herein.

At least one heat-generating electronic device 50 may be mounted or electrically connected to the printed circuit board 34. Examples of a heat-generating electronic device 50 include, but are not limited to a processor such as a central processing unit and/or graphics processing unit, memory, a hard drive, and a power supply module. In an embodiment, one or more fans 52 are mounted to the printed circuit board 34 and are operable to move a flow of a fluid, such as air over the heat-generating electronic devices 50. In the illustrated, non-limiting embodiment, the at least one fan 52 is arranged near a first end 54 of the printed circuit board 34 such that when the server 30 is installed within the cabinet 22 the at least one fan 52 is positioned closer to the front of the cabinet 22 than the heat-generating electronic devices 50. However, embodiments where one or more fans 52 are arranged at another suitable location, such as near a second end 56 of the printed circuit board 34 or of the chassis 32 associated with the rear of the cabinet 22 for example, are also within the scope of the disclosure.

In an embodiment, the fluid moved by the at least one fan 52 is configured to make a single pass over the heat-generating electronic devices. For example, cool air may be drawn into the fan 52 from a location adjacent to the front of the chassis 32 and after removing heat from the heat-generating electronic devices 50, the hot air may be exhausted at the back of the chassis 32. In other embodiments, such as where the chassis 32 includes at least one flat panel 42 for example, the fluid may be configured to continuously circulate within the server 30. For example, as best shown in FIG. 2B, a fan 52 may push the flow of fluid across the heat-generating electronic devices 50 arranged at a first surface 58 of the printed circuit board 34. Upon reaching the second end 56 of the printed circuit board 34, the fluid may turn through one or more openings and make a second pass along the second, opposite side 60 of the printed circuit board 34. Upon reaching the first end 54 of the printed circuit board 34, the fluid may turn again, and be drawn back into an inlet of the at least one fan 52.

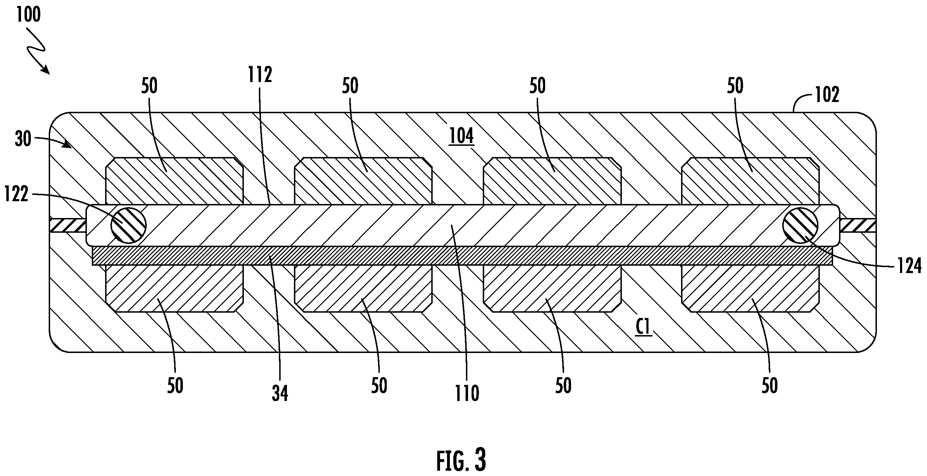

With reference now to FIG. 3, an example of an assembly 100, such as a server 30 having an integral cooling system for example, is illustrated. Similar to the server 30 illustrated in FIGS. 2A and 2B, in the illustrated, non-limiting embodiment, the assembly 100 includes a server 30 having a chassis 32, at least one printed circuit board 34 mounted thereto, and at least one heat-generating electronic device 50 mounted or electrically connected to the printed circuit board 34. In the illustrated, non-limiting embodiment, the server 30 includes four heat-generating electronic devices 50. However, it should be understood that embodiments where the server 30 includes one, two, three, or more than four heat-generating electronic devices 50 are also within the scope of the disclosure.

The assembly 100 additionally includes a sealed container 102 and the server 30 in its entirety may be enclosed or encased within the interior 104 of the sealed container 102. The sealed container 102 may be formed from the chassis 32 and a plurality of flat panels 42 as previously described or may be a separate container positionable about the server 30. In an embodiment, the container 102 is hermetically sealed to prevent the flow of any fluid out of the interior 104 of the container 102. The interior 104 of the container 102 may be filled with a first cooling medium C1 such that the heat generating electronic devices 50 are submerged or encapsulated within the first cooling medium C1. As the first cooling medium C1 contacts the one or more heat-generating electronic devices 50, the first cooling medium C1 is configured to absorb heat, thereby removing the heat from the more heat-generating electronic devices 50. In an embodiment, the first cooling medium C1 is a dielectric fluid. The first cooling medium C1 may include a single dielectric fluid, or alternatively, may include a mixture of two or more dielectric fluid having different boiling points.

The density of a dielectric fluid is configured to vary with the temperature of the dielectric fluid. Accordingly, the resulting density changes as the dielectric fluid absorbs heat may cause a natural circulation of the dielectric fluid within the container 102. However, in other embodiments, a fluid movement mechanism, such as a pump or circulator for example, may be positioned within the interior 104 of the container 102 in fluid communication with the first cooling medium C1.

In an embodiment, the assembly 100 includes a heat sink 110 arranged within the interior 104 of the container 102. In the illustrated, non-limiting embodiment, the heat sink 110 is arranged at a center of the container 102. Embodiments where the heat sink 110 is arranged at another location within the container 102 are also contemplated herein. As shown, the heat sink 110 may be mounted directly to the printed circuit board 34. Accordingly, the heat sink 110 may be indirectly thermally coupled to one or more of the heat-generating electronic devices 50 via the printed circuit board 34. Alternatively, or in addition, one or more heat-generating electronic devices 50 that are not mounted to the printed circuit board 34 may be mounted directly to a surface 112 of the heat sink 110. Such heat-generating electronic devices 50 may be considered to be directly thermally coupled to the heat sink 110. The heat-generating electronic devices 50 that are either directly coupled to the heat sink 110 or are indirectly coupled to the heat sink 110 via the printed circuit board 34 may be referred to herein as selected heat-generating devices. Similarly, the heat-generating electronic devices 50 of the server 30 that are not directly thermally coupled to the heat sink 110 or indirectly thermally coupled to the heat sink 110 via the printed circuit board 34 may be considered "peripheral" heat-generating devices 50.

In an embodiment, the heat sink 110 is a cold plate having an internal fluid circuit 120 configured to receive a second cooling medium C2 to remove heat therefrom. It should be appreciated that the first and second cooling mediums C1, C2 described herein may be the same, or alternatively, may be distinct or different mediums or fluids. Further, although only a single cold plate 110 is illustrated, it should be appreciated that embodiments including a plurality of cold plates fluidly coupled in parallel or in series are also within the scope of the disclosure.

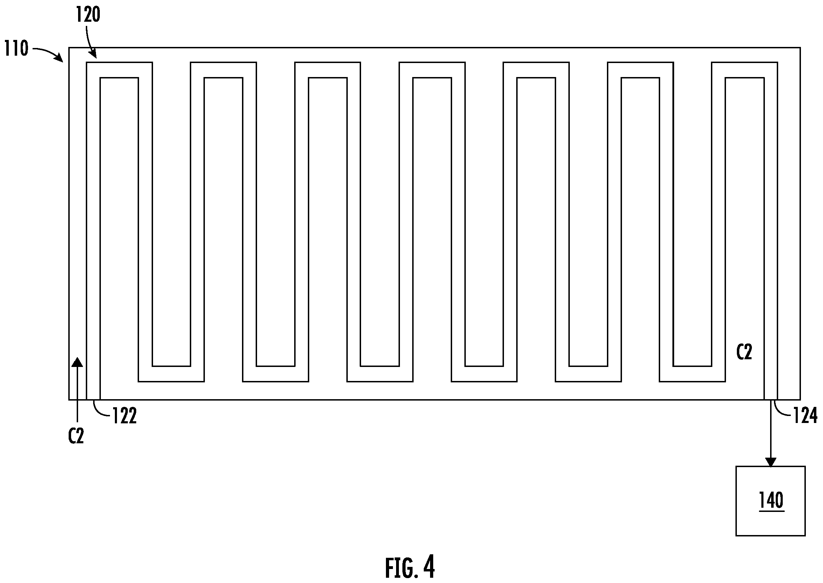

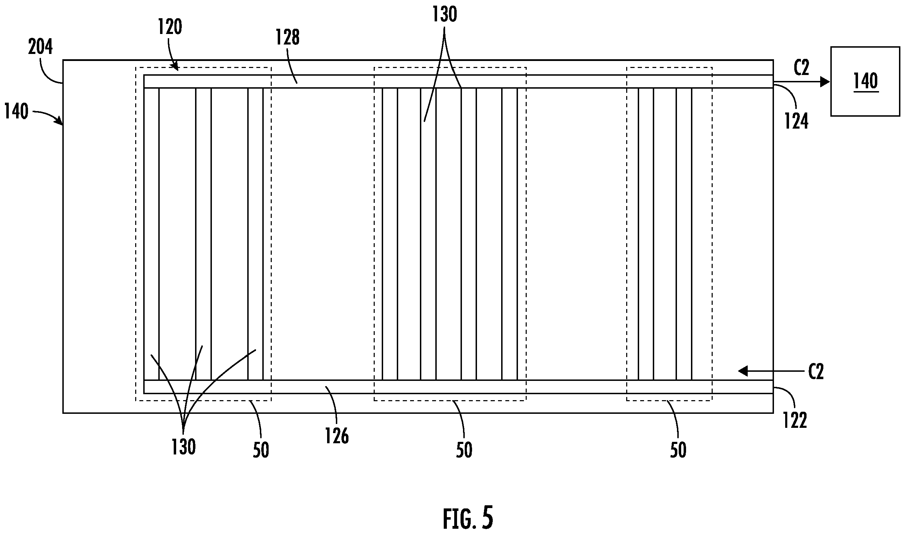

Examples of an internal fluid circuit 120 of the heat sink 110 are illustrated in the cross-sectional views shown in FIG. 4 and 5. As shown, the fluid circuit 120 includes a fluid inlet 122 and a fluid outlet 124 formed in the body of the cold plate. The fluid inlet 122 and the fluid outlet 124 can be any shape, such as in the depth dimension (e.g., in the z-x plane of the attached figure), including the shape of a circle, oval, triangular, square, rectangular, or any simple polygonal shape or portion thereof. Also, in an embodiment, the fluid outlet 124 can have a much larger diameter compared to the fluid inlet 122, thereby helping to reduce the pressure drop for a second cooling medium C2 passing through the fluid outlet 124.

In an embodiment, best shown in FIG. 4, the fluid circuit 120 includes a continuous flow path having a serpentine configuration extending between the fluid inlet 122 and the fluid outlet 124. However, in other embodiments, as shown in FIG. 5, the fluid circuit 120 may include a first or inlet manifold 126, a second or outlet manifold 128, and at least one fluid passage 130 connecting the first and second manifolds 126, 128. In an embodiment, the at least one fluid passage 130 includes a plurality of fluid passages 130.

In an embodiment, one or more fluid passages 130 of the fluid circuit 120 may be positioned to perform localized cooling at the area of the heat sink 110 with the greatest heat flux, such as at the area of the heat sink 110 directly aligned with or in overlapping arrangement with a heat-generating electronic device 50. Accordingly, the at least one fluid passage 130 may be associated with at least one selected heat-generating electronic device 50. In embodiments where the heat sink 110 is associated with a plurality of selected heat-generating electronic devices 50, one or more fluid passages 130 may be associated with and configured to remove heat from each of the respective selected heat-generating electronic module. More specifically, the at least one fluid passage 130 associated with a respective selected heat-generating electronic device 50 may be physically located within the cold plate 110 in overlapping arrangement or in alignment with the selected heat-generating electronic device 50. In an embodiment, the total number of fluid passages 130 arranged within a localized area of increased heat flux associated with a respective heat-generating electronic device 50 may vary based on the heat required to be removed from the respective heat-generating electronic device 50. As a result, a different number of fluid passages 130 may be aligned with each heat-generating electronic device 50 associated with the heat sink 110, as shown in FIG. 5.

During operation of the server 30 of assembly 100, the heat generating electronic devices 50 are cooled via two different types of cooling. The first type of cooling includes direct cooling of one or more peripheral heat-generating devices 50 using the first cooling medium C1 within the interior 104 of the container 102. The first cooling medium C1 is arranged in direct contact with one or more surfaces of the at least one peripheral heat-generating device 50. Accordingly, as the first cooling medium C1 circulates or moves through the interior 104, heat is transferred from the peripheral heat-generating devices to the first cooling medium C1. In some embodiments, since the first cooling medium C1 is also configured to contact one or more surfaces of the one or more selected heat-generating electronic devices 50, the first cooling medium C1 may also be configured to cool the selected heat-generating electronic devices 50.

The second type of cooling of the assembly 100 includes the removal of heat from the at least one selected heat-generating electronic device 50 by the heat sink 110. As previously noted, the selected heat-generating devices may include one or more of the heat-generating electronic devices 50 mounted to the printed circuit board 34 and/or one or more heat-generating electronic devices 50 mounted directly to the heat sink 110. In operation, at least a portion of the heat generated by the at least one selected heat-generating electronic device 50 is transferred to the body of the heat sink 110, such as via conduction for example. At the same time, a second cooling medium C2, such as a refrigerant for example, is provided to the fluid inlet 122 of the fluid circuit 120. The second cooling medium C2 provided to the fluid circuit 120 may be a liquid, or alternatively, many be a two-phase mixture of liquid and vapor. As the second cooling medium C2 passes through the fluid circuit 120, at least a portion of the heat transferred to the heat sink from the at least one selected heat-generating electronic device 50 is transferred from the body of the heat sink 110 to the second cooling medium C2. The heat transferred to the second cooling medium C2 causes the temperature of the second cooling medium C2 within the fluid circuit to increase. Accordingly, the temperature of the second cooling medium C2 at the fluid outlet 124 is greater than the temperature of the second cooling medium C2 at the fluid inlet 122. Further, in some embodiments, this heat transfer may cause at least a portion of the second cooling medium C2 within the fluid circuit 120 to vaporize.

Further, the heat sink and the second cooling medium C2 may be used to condition the first cooling medium C1 by removing heat therefrom, such that the first cooling medium C1 has a temperature suitable to remove heat from the one or more peripheral heat-generating devices and/or the one or more heat-generating electronic devices thermally coupled to the heat sink 110. Accordingly, the first cooling medium C1 may be cooled by the heat sink 110 at a position upstream from the one or more peripheral heat-generating devices relative to a direction of flow of the first cooling medium C1 within the container 102. The first cooling medium C1 within the interior 104 of the container 102 is configured to contact one or more surfaces of the heat sink 110. As a result of this contact, at least a portion of the heat absorbed by the first cooling medium C1 from the peripheral heat-generating devices 50 may be transferred to the heat sink 110, thereby cooling the first cooing medium C1. This heat is removed from the body of the heat sink 110 in combination with the heat transmitted thereto from the at least one selected heat-generating electronic devices 50 via the flow of the second cooling medium C2 within the fluid circuit 120.

The heated secondary cooling medium C2 is output from the fluid outlet 124 of the fluid circuit 120 may be directed to one or more downstream loads, illustrated schematically at 130. The heat removed from the primary cooling medium C1 the at least one selected heat-generating electronic device 50 by the secondary cooling medium fluid C1 may be exhausted to another fluid at the one or more loads 140. For example, in an embodiment, the downstream load is a hot water heater or an air conditioning system of the building.

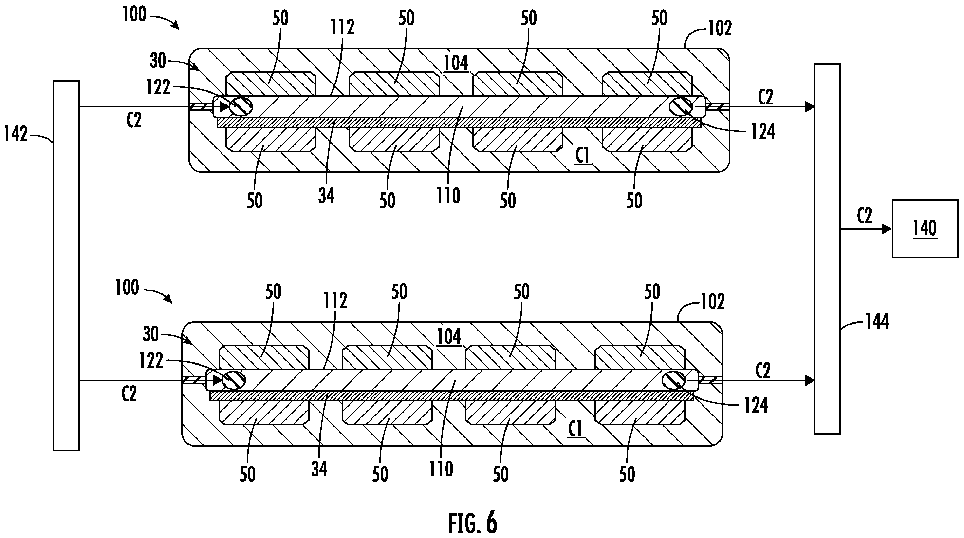

In an embodiment, best shown in FIG. 6, a plurality of assemblies 100 may be arranged within a cabinet 22 or other data center. In such embodiments, the secondary cooling medium C2 may be provided to each of the plurality of assemblies 100 in series or in parallel. In embodiments where the assemblies 100 are arranged in parallel, an inlet manifold 142 may be fluidly coupled to the fluid inlet 122 of each fluid circuit 120 and an outlet manifold 144 may be fluidly coupled to the fluid outlet 124 of each fluid circuit 120. In such embodiments, the heated second cooling medium C2 collected within the outlet manifold 144 from each of the assemblies 100 is mixed and then delivered to the one or more downstream loads 140.

An assembly 100 having an integral cooling system as illustrated and described herein provides an easily scalable solution for cooling heat-generating components. Such a cooling solution can improve the sustainability and efficiency of the heat-generating components by rejecting the heat absorbed from the heat-generating component to a downstream heating application. In addition, the air conditioning load for cooling an area containing a data center is reduced.

The term "about" is intended to include the degree of error associated with measurement of the particular quantity based upon the equipment available at the time of filing the application.

The terminology used herein is for the purpose of describing particular embodiments only. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements of the embodiments without departing from the scope of the present invention, which is defined by the claims. In addition, many modifications may be made to adapt a particular situation or material to the teachings of the present invention. Therefore, it is intended that the present invention not be limited to the particular embodiment disclosed, but that the present invention will include all embodiments falling within the scope of the claims.

## Claims

1. A method of cooling an assembly (30; 100) including at least one heat-generating electronic device (50) and at least one peripheral heat-generating device (50) encapsulated within a container (32, 42; 102), the method comprising:
cooling the at least one peripheral heat-generating device (50) with a first cooling medium (C 1);
cooling the at least one heat-generating electronic device (50) with a heat sink (110) having an internal fluid circuit (120) configured to receive a second cooling medium (C2); and
cooling the first cooling medium (C1) via the heat sink.

2. The method of claim 1, wherein the heat sink (110) is a cold plate.

3. The method of claim 1 or claim 2, comprising circulating the first cooling medium (C1) within the container (32, 42; 102);
optionally wherein the first cooling medium (C1) is cooled via the heat sink (110) at a location upstream from the at least one peripheral heat-generating device (50) relative to a direction of flow of the first cooling medium (C1).

4. The method of any preceding claim, comprising cooling the at least one heat-generating electronic device (50) with the first cooling medium (C1).

5. The method of any preceding claim, wherein cooling the at least one heat-generating electronic device (50) with the heat sink (110) having the internal fluid circuit (120) comprises:
transferring heat from the at least one heat-generating electronic device (50) to a body of the heat sink (110); and
transferring heat from the body of the heat sink (110) to the second cooling medium (C2) within the fluid circuit (120);
optionally wherein the at least one heat-generating electronic device (50) is directly mounted to a surface (112) of the heat sink (110).

6. The method of claim 5, wherein the at least one heat-generating electronic device (50) is directly mounted to a printed circuit board (34) and the heat sink (110) is thermally coupled to the printed circuit board (34).

7. The method of any preceding claim, wherein cooling the at least one heat-generating electronic device (50) with the heat sink (110) having the internal fluid circuit (120) comprises positioning a portion of the fluid circuit (120) in overlapping arrangement with the at least one heat-generating electronic device (50).

8. The method of any preceding claim, wherein cooling the first cooling medium (C1) via the heat sink (110) comprises:
conducting heat from the first cooling medium (C1) to a body of the heat sink (110); and
transferring heat from the body of the heat sink (110) to the second cooling medium (C2).

9. The method of any preceding claim, wherein the first cooling medium (C1) is a dielectric fluid, and/or wherein the second cooling medium (C2) is a refrigerant.

10. An assembly (30; 100) comprising:
a fluid-tight container (32, 42; 102);
at least one heat-generating electronic device (50) arranged within the container (32, 42; 102);
at least one peripheral heat-generating device (50) arranged within the container;
a first cooling medium (C1) arranged within the container (32, 42; 102), the at least one heat-generating electronic device (50) and the at least one peripheral heat-generating device (50) being encapsulated by the first cooling medium (C1); and
a heat sink (110) thermally coupled to the at least one heat-generating electronic device (50), the heat sink (110) having an internal fluid circuit (120) configured to receive a second cooling medium (C2).

11. The assembly of claim 10, wherein the heat sink (110) is a cold plate.

12. The assembly of claim 10 or claim 11, wherein the at least one heat-generating electronic device (50) is directly mounted to the heat sink (110); or
wherein the assembly (30; 100) comprises a printed circuit board (34), the at least one heat-generating electronic device (50) being directly mounted to the printed circuit board (34) and the heat sink (110) being thermally coupled to the printed circuit board (34).

13. The assembly of any of claims 10-12, comprising a movement mechanism for moving the first cooling medium (C1) within the container (32, 42; 102).

14. The assembly of any of claims 10-13, wherein the internal fluid circuit (120) of the heat sink (110) includes a single continuous path or wherein the internal fluid circuit (120) of the heat sink (110) includes a first manifold (126), a second manifold (128), and at least one fluid passage (130) connecting the first and second manifolds; and/or
wherein at least a portion of the internal fluid circuit (120) is positioned in overlapping arrangement with the at least one heat-generating electronic device (50).

15. The assembly of any of claims 10-14, wherein the first cooling medium (C1) is a dielectric fluid.
